# EUROPEAN PATENT APPLICATION

(11) **EP 4 794 194 A1**
(43) Date of publication of application: **19.08.2026**
(21) Application number: 25157772.2
(22) Date of filing: 13.02.2025
(51) Int. Cl.: H03B 5/06, H03B 5/36

(54) **CO-DESIGN OF AN ELECTRONIC DRIVER CIRCUIT AND A RESONATOR ELE-MENT**

(71) Applicant: ETH Zurich, 8092 Zurich (CH)
(72) Inventor: Jang, Taekwang, 8057 Zurich (CH); Livanelioglu, Can, 8053 Zurich (CH); He, Long, 8052 Zurich (CH)
(74) Representative: Gygi, Andreas

(57) **Abstract**

The invention relates to an electronic driver circuit (EDC) for driving a resonator element (XO) for providing an electronic oscillator (1). The electronic driver circuit (EDC) comprises: a synthesizer section (SYN) which is configured to receive a reference signal (XO_SIG.N, XO_SIG.P) from the resonator element (XO) and to generate a synthesizer signal (SYN_SIG) having a synthesizer frequency (SYN_F) which is equal to, lower or higher than a reference frequency (XO_F) of the reference signal (XO_SIG.N, XO_SIG.P), and having in particular a phase resolution below or equal to 90 degrees with respect to the reference signal (XO_SIG.N, XO_SIG.P); and a pulse injection section (PJD.N, PJD.P) which is configured to inject an injection signal (INJ.N, INJ.P) into the resonator element (XO) at an injection time (T.N, T.P) which is selected using the synthesizer signal (SYN_SIG), or using the synthesizer signal (SYN_SIG) and the reference signal (XO_SIG.N, XO_SIG.P). The electronic driver circuit (EDC) enables providing an electronic oscillator (1) having improved power and noise efficiency.

## Description

### FIELD OF THE INVENTION

The present invention relates to an electronic driver circuit for a resonator element for providing an electronic oscillator and frequency generator. The resonator element can relate to a synchronized resonator element or an asynchronous resonator element.

### BACKGROUND ART

Electronic oscillators typically use a Pierce driver (US2133642), Colpitts, Clapp, Butler, modified Butler and other driver circuits, which are a combination of transistor, resistor and capacitor unit or units driving a resonator element using a voltage and or current signal, from the resonator element as an input. This comprises resonator elements such as crystals, MEMS resonators (MEMS: micro-electromechanical systems) and ring resonators. The driver receives directly or indirectly a certain amount of electrical power from a supply, which is a unit providing stationary or nonstationary DC or AC voltage or current, whose net output power toward the driver circuit is defined as the integral of the multiplication of the supply voltage and supply current for a certain specific time window. Some portion of this received power is injected into the resonator element to restore the electrical losses in the resonator element and sustain its oscillation amplitude while the remaining part is dissipated in the driver. This defines the power-efficiency of the Pierce driver as the ration between the power injected into the resonator element to the total power drawn from the supply.

Moreover, the electrical circuits of the driver have electronic noise, which may be thermal or Johnson-Nyquist, shot, flicker or 1/f, partition, burst, transit-time noise; as well as coupled noise such as coupled electrical or supply noise, intermodulation noise, crosstalk, interference of the medium and the surroundings, solar/atmospheric/cosmic noise. The noise is injected into the resonator element by the driver during the energy-injection process, which distorts the amplitude and/or phase of the oscillation. The extent of the amplitude and/or phase distortion depends on the time when the noise respectively energy-injection process occurs and is characterized by the impulse-sensitivity-function (ISF) (A. Hajimiri and T. H. Lee, "A general theory of phase noise in electrical oscillators," in IEEE Journal of Solid-State Circuits, vol. 33, no. 2, pp. 179-194, Feb. 1998, doi: 10.1109/4.658619), which fully represents itself as an amplitude distortion if applied at the global minima and maxima of the oscillation waveform where the time-derivative is zero; and fully represents itself as phase distortion if applied at the point where the time-derivative of the oscillation waveform is at its global maxima or minima. For frequency-generation-and-synthesis and timing applications, the phase perturbations are more critical than amplitude perturbations since the phase perturbation gives rise to phase noise or timing jitter, both of which are a measure of how precise the timing of the electronic oscillator is compared to a fully ideal, noiseless reference electronic oscillator.

In the light of the power-efficiency and impulse sensitivity, the Pierce driver is not an efficient driver because some or most energy is injected into the resonator element mostly when the outputs of the resonator element are transitioning between their high and low voltages during the interval where the derivative of the oscillation waveform attains its global maxima and minima; thereby some or most perturbation of the driver, including electronic noise, exhibits mostly as phase perturbations which is undesirable for frequency-generation-and-synthesis and timing applications. Additionally, since the Pierce driver injects current when the difference between the oscillation voltage and the supply voltages are the greatest, a meaningful portion of the energy is dissipated in the driver instead of being injected into the resonator element, per oscillation cycle. This results in a reduction in the power efficiency of the Pierce driver.

To work around these shortcomings regarding power and noise, certain drivers condense the energy-injection near the oscillation maxima or minima regions to mitigate the driver-to-phase perturbation and improve performance for frequency-generation-and-synthesis applications. This art-of-drivers utilize the outputs of the driven resonator to introduce the amount of delay to align the energy-injection with the aforementioned low driver-to-phase perturbation regions, using various timing-delay-generating circuits including but not limited to analog or digitally-controlled delay lines, phase interpolators, delay-locked-loops (DLLs), phase-locked-loops (PLLs), digital-to-time-converters (DTCs) and/or logic circuits. They then adopt pulse-generating circuits to create a pulse from precisely delayed oscillations of the driven resonator to inject with low phase perturbation and high injection efficiency.

However, these delay/timing and pulse generation circuits are additive elements to the frequency reference system. Therefore, they come with power and noise overhead for the frequency reference system and for the frequency-generation-and-synthesis systems.

Y. Zeng, T. Jang, Q. Dong, M. Saligane, D. Sylvester and D. Blaauw, "A 1.7nW PLL-assisted current injected 32KHz crystal oscillator for loT," 2017 Symposium on VLSI Circuits, Kyoto, Japan, 2017, pp. C68-C69, doi: 10.23919/VLSIC.2017.8008551, employs a PLL to achieve low-phase-perturbation energy-injection to the resonator element. The PLL functions as an alternative to a delay element where the driver relies on a noise and power-inefficient pulse generator to generate a low temporal resolution to inject pulses of energy.

### DISCLOSURE OF THE INVENTION

There may be a need for an electronic driver circuit for a resonator element for providing an electronic oscillator which improves disadvantages of the prior art. In particular, there may be a need for an electronic driver circuit for a resonator element for providing an electronic oscillator which enables improving one or more of phase noise, jitter and power consumption.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to an electronic driver circuit for driving a resonator element for providing an electronic oscillator. The electronic driver circuit comprises: a synthesizer section which is configured to receive a reference signal from the resonator element and to generate a synthesizer signal having a synthesizer frequency which is equal to, lower or higher than a reference frequency of the reference signal, and having in particular a phase resolution below or equal to 90 degrees with respect to the reference signal, where the phase resolution is defined as 360 degrees with respect to the reference signal divided by the frequency multiplication ratio of the synthesizer section and further divided by the number of phases at the output of the synthesizer section; and a pulse injection section which is configured to inject an injection signal into the resonator element at an injection time which is selected using the synthesizer signal, or using the synthesizer signal and the reference signal. Predetermined and reduced phase resolution enables enhancing the minimum available timing resolution of the frequency generation system to condense and align the energy-injection to improve the phase-perturbation of the driver. The frequency of injection to the resonator element can be same, integer multiple or fractional multiple of the frequency of the resonator element and the resonator element can be driven with injections synchronous or asynchronous to the resonator element and/or the synthesizer section.

According to the present invention, the synthesizer is generating the injection timing in the resolution of the 90 degrees or below of the reference phase without a help of a pulse width generator. Pulse width generator is a unit defining the duration of the injection. Duration of the injection is a time where 50% or more energy is injected into the resonator from the total energy injected into the resonator per cycle.

The invention relates to a co-design of an electronic driver circuit and a resonator element. A holistic design according to the invention enables to provide an electronic oscillator having improved performance. The invention enables a bidirectional feed-back, feed-forward signal flow between the electronic driver circuit and the resonator element in which the electronic driver circuit improves the noise and/or power-efficiency of the resonator element driver by any means (feed-back) and the resonator element provides the direct or indirect reference signal for the synthesizer (feed-forward).

In some embodiments, the electronic driver circuit has a single or multiple, series and/or parallel and/or cascaded connected and/or structured, same and/or combinatorial design.

In some embodiments, the electronic driver circuit includes a detection circuit, which is configured to find the global minima and maxima of the oscillation waveform where the time-derivative is zero, i.e. low phase perturbation points, i.e. low impulse-sensitivity-function points, i.e. optimum points of energy-injection; or to find if the utilized resonator element driver timing is accurate or not. The detection circuit can be configured to observe any internal and/or external node within the resonator element and/or within the electronic driver circuit. The detection circuit can be configured to use voltage, current, charge, phase, frequency, delay or any other means to observe the timing of the injection. The detection circuit can include any additional circuit to improve the time resolution of the injection time.

In some embodiments, the electronic oscillator can include a control circuit. The control circuit can be configured to determine the injection time. The control circuit can be placed within the resonator element and/or electronic driver circuit. The control circuit can be configured to tune and/or control the energy-injection timing. The control circuit can be configured to use the periodic resolutions already available in the system as well as any circuit means to produce multiples or fractions of the available periods. The control circuit can include resistive-capacitive (RC) circuits and/or inductive-capacitive (LC) circuits and/or transmission line circuits and/or constant and/or variable current and/or slope charging delay circuits, such as analog or digitally-controlled delay line and/or delay-locked-loops and/or locked single or multi-phase frequency or phase-locked loop outputs and/or digital-to-time-converter (DTC) and/or phase interpolator and/or slope generation circuits and/or counter circuits and/or frequency divider circuits.

In some embodiments, the electronic driver circuit includes a single phase or multi-phase unit, or units of a phase looked loop (PLL), frequency doubler and/or tripler and/or quadrupler, direct digital frequency synthesizer (DDFS), injection-locked clock synthesizer, multiplying delay-locked-loop (MDLL), phase interpolator and/or edge combiner.

In some embodiments, the resonator element relates to a single and/or multiple, series and/or parallel connected and/or structured, integrated and/or discrete, single-phase or multi-phase crystal and/or microelectromechanical (MEMS) and/or ring and/or inductor-capacitor (LC) oscillator, surface-acoustic-wave (SAW) and/or bulk-acoustic-wave (BAW) resonator. The co-design can be adapted to various types of resonator elements.

In some embodiments, the injection signal relates to one or more of a voltage signal, a current signal, and a charge signal. The injection signal and/or signals can be applied to any number and/or combination of ports of the resonator element with a synchronized and/or asynchronized and/or in-phase and/or symmetrical and/or anti-symmetrical and/or differential nature.

In some embodiments, the electronic driver circuit is configured to select the injection time according to an impulse-sensitivity-function. The impulse-sensitivity-function enables selecting an advantageous injection time, as regards to phase noise, jitter, or power consumption.

In some embodiments, the electronic driver circuit is configured to select the injection time to reduce one or more of phase noise, timing jitter, and power consumption.

In some embodiments, the synthesizer frequency is an integer multiple or a fractional multiple of the reference frequency.

In some embodiments, the electronic driver circuit has a monolithic design. The electronic driver circuit can relate to an integrated circuit.

In some embodiments, the electronic driver circuit has a discrete electronic design. The electronic driver circuit can relate to a printed circuit board.

In some embodiments, the electronic driver circuit has a combination of integrated and discrete design. The electronic driver circuit can relate to integrated circuit or circuits and printed circuit board or boards.

In some embodiments, the synthesizer section includes one or more of a buffer circuit, a phase-looked-loop circuit, any other frequency synthesizing circuit, any other phase generating circuit and a controlled oscillator circuit. The controlled oscillator circuit can relate to a voltage-controlled oscillator circuit or a digitally-controlled oscillator circuit.

A phase-looked loop (PLL) can relate to a reference-sampling PLL (RSPLL), a reference over-sampling PLL (ROSPLL), a sub-sampling PLL (SSPLL), an all-digital PLL (ADPLL), a bang-bang PLL (BBPLL), an injection-locked or injection-assisted PLL, an integer or fractional-N PLL, a PLL with and/or without reference doubling, tripling, quadrupling or any integer multiplication of the reference signal frequency to the PLL including single and multi-phases. The controlled oscillator can include ring, series or parallel LC oscillators of any arbitrary topology and/or single or multi-phase structures and can be analog and/or digital tunable via current and/or voltage and/or capacitance and/or inductance and/or digital code. The PLL may or may not feature any circuit performing phase and/or frequency error detection block, such as any kind of sampling phase detector, phase-frequency-detector, tri-state phase detector, bang-bang phase detector, XOR based phase detector; a frequency matching block i.e. divider, any circuit to control the controlled oscillator based or not based on the error detector result, i.e. analog or digital integrated or discrete loop filter, charge-pumps, amplifiers, samplers, injection-locking circuits, continuous and/or discrete-time integration circuits.

In some embodiments, the electronic driver circuit further includes a Pierce oscillator section which is configured to start-up the electronic oscillator. The Pierce oscillator section can include an inverter and switches, wherein with closed switches a Pierce oscillator can be formed.

The invention also relates to an electronic oscillator comprising an electronic driver circuit according to the invention connected to a resonator element.

The invention also relates to a printed circuit board comprising an electronic oscillator according to the invention.

The invention further relates to a method of operating an electronic oscillator comprising a resonator element. The method comprises the steps: receiving a reference signal from the resonator element and generating a synthesizer signal having a synthesizer frequency which is equal to, lower or higher than a reference frequency of the reference signal, and having in particular a phase resolution below or equal to 90 degrees with respect to the reference signal; and injecting an injection signal into the resonator element at an injection time which depends on the synthesizer signal, or which depends on the synthesizer signal and the reference signal.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a circuit diagram of an electronic oscillator according to the prior art.
Fig. 2 shows a circuit diagram of another electronic oscillator according to the prior art.
Fig. 3 shows a simulation result of signals of a resonator element and a respective impulse sensitivity function.
Fig. 4 shows a comparison in the light of impulse sensitivity of a Pierce driver and the pulse-injection of an embodiment of an electronic driver circuit according to the present invention.
Fig. 5 shows schematically an embodiment of an electronic driver circuit for a resonator element for providing an electronic oscillator according to the present invention.
Fig. 6 shows possible method steps of operating an electronic oscillator according to the present invention.
Fig. 7 shows possible signals of operating an electronic oscillator with an electronic driver circuit according to the present invention.

The figures are only schematic and not to scale. Same reference signs refer to same or similar features.

### MODE(S) FOR CARRYING OUT THE INVENTION

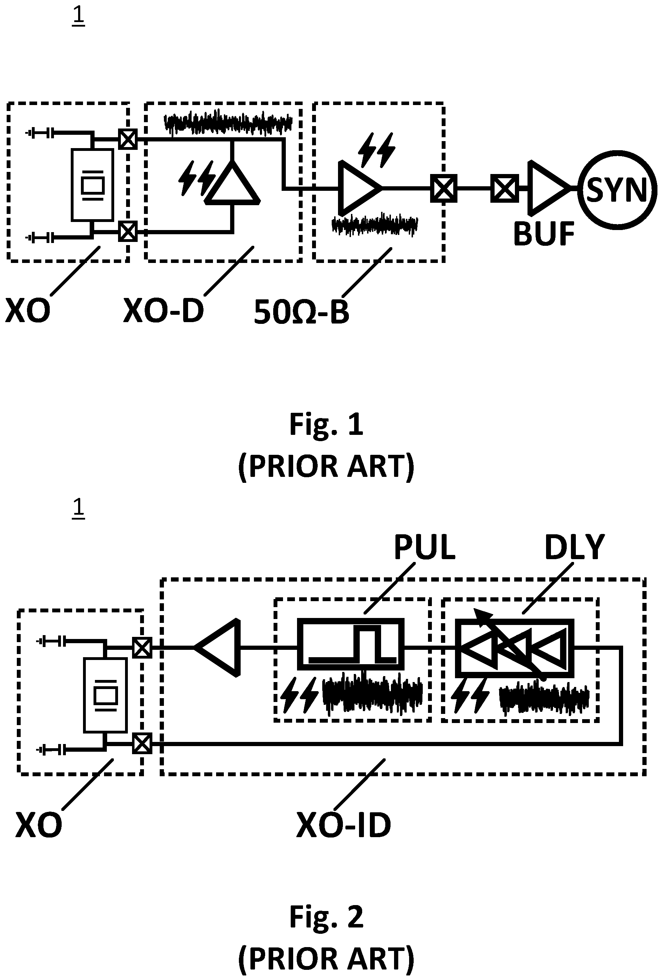

Fig. 1 shows a circuit diagram of an electronic oscillator 1 according to the prior art. A resonator element XO, which includes a crystal and zero, two or any arbitrary number of capacitors, is connected to a crystal driver section XO-D, which includes a driving circuit, which is a combination of transistor, resistor and capacitor unit or units. The resonator element XO and the crystal driver section XO-D form a Pierce oscillator. The crystal driver section is connected to a 50Ω buffer section 50Ω-B. The 50Ω buffer section 50Ω-B can be connected to a frequency synthesizer, which can be a phase-locked loop PLL. The electronic oscillator 1 according to Fig. 1 can achieve low phase noise, e.g. <-170dBc/Hz up to several hundreds of MHz. As schematically shown in Fig. 1, power consumption is high, e.g. >100 mW, resulting in low efficiency. Furthermore, the 50Ω buffer section 50Ω-B suffers from a power and noise overhead.

Fig. 2 shows a circuit diagram of another electronic oscillator 1 according to the prior art, such as a 32kHz Ultra-Low-Power crystal oscillator. A resonator element XO, which includes a crystal and zero, two or any arbitrary number of capacitors, is connected to a pulse-injection driver XO-ID, which receives an input signal from the resonator element XO. The pulse-injection driver XO-ID includes a delay circuit, which delays the XO signal by a quarter cycle. The pulse-injection driver XO-ID includes a pulse generator, which generates a pulse from the delay circuit signal. A current is injected at the XO peak and valley regions using the pulse. The injection efficiency, which is calculated as the ration between the energy received by the XO and drawn from supply, can be above 90% with this implementation. Energy injection at low Impulse-Sensitivity-Function regions is enabled. However, the delay/timing and pulse generation circuits are additive elements to the frequency reference system.

Therefore, they come with power and noise overhead for the frequency reference system and for the frequency-generation-and-synthesis systems, making the overall performance of this implementation similar to that of a conventional Pierce oscillator in high-frequency application above tens of MHz, hindering its applicability and efficiency.

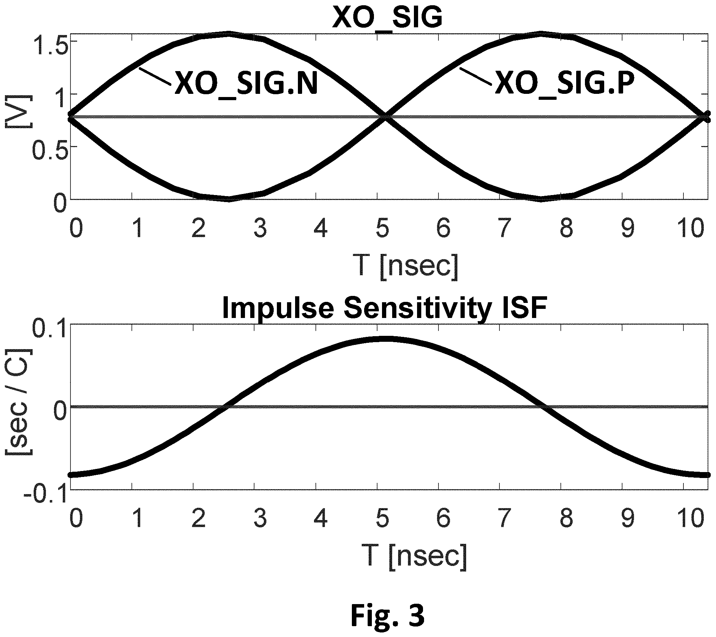

Fig. 3 shows a simulation result of signals XO_SIG.P and XO_SIG.N of a resonator element, and a respective impulse sensitivity function ISF. For the resonator element, a perturbation from a driver circuit or any other source causes a distortion of the oscillation phase, i.e. timing of the oscillator signal compared to a fully ideal, noiseless reference resonator element. The impulse-sensitivity-function ISF defines the extent of the phase and/or timing error resulting from a perturbation on the resonator element as a function of the time the perturbation is applied. When the perturbation and/or noise is applied at a point where the time-derivative of the oscillation waveform is at its global maxima or minima, i.e. the crossing point of signals XO_SIG.P and XO_SIG.N, the phase/timing error is maximum. When the perturbation and/or noise is applied at the global minima and maxima of the XO_SIG.P and XO_SIG.N, i.e. where the time-derivative is zero, then the phase/timing error is minimum. This fact about electronic oscillators and resonator elements constitutes the theoretical foundation for the invention.

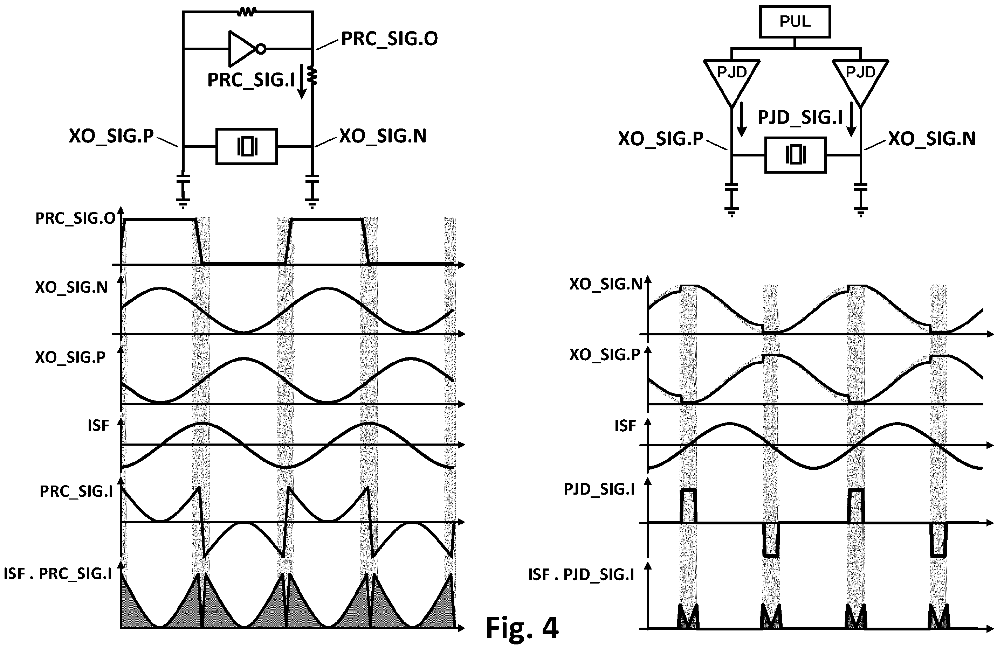

Fig. 4 shows a comparison in the light of impulse sensitivity of a Pierce driver and the pulse injection driver of an embodiment of an electronic driver circuit EDC according to the present invention, which will be described in more detail below. Pierce driver injects most current around the crossing point of XO_SIG.P and XO_SIG.N, where the ISF is maximum. The pulse injection section PJD.N, PJD.P of the electronic driver circuit EDC according to the present invention injects pulses of current around global minima and maxima of the XO_SIG.P and XO_SIG.N, where the ISF is minimum. The multiplication of the impulse-sensitivity-function ISF with the injected current of the respective drivers demonstrates the extent of noise injection by the drivers to the resonator element. By featuring a pulse injection section PJD.N, PJD.P, the electronic driver circuit EDC according to the present invention enables reduced impulse sensitivity and reduced electronic oscillator phase noise. By injecting in the regions with low voltage drop across the oscillator signal and pulse injection section PJD.N, PJD.P output signal, the electronic driver circuit EDC according to the present invention enables reduced power consumption.

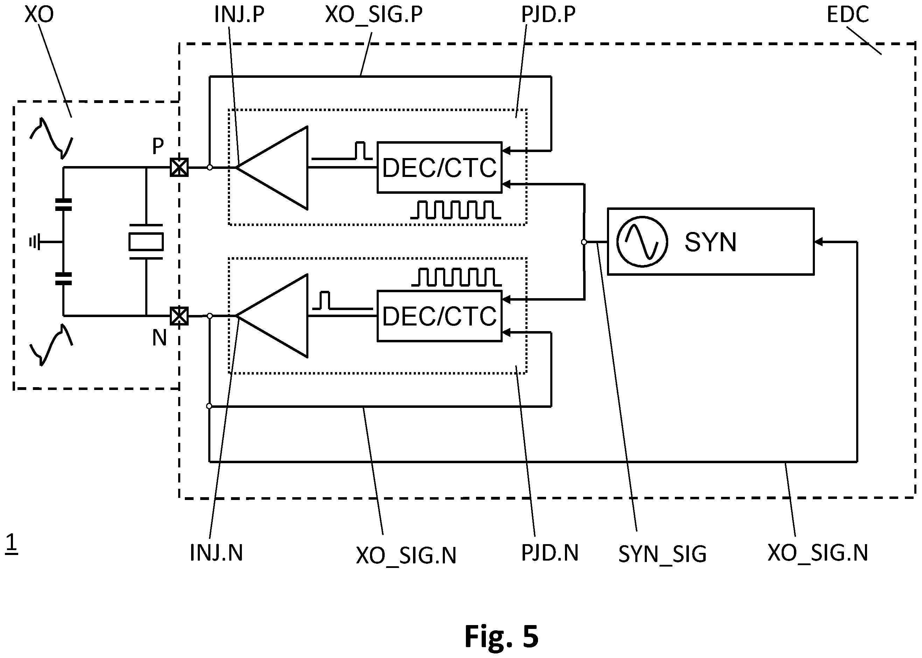

Fig. 5 shows schematically an embodiment of an electronic driver circuit EDC according to the present invention. As illustrated in Fig. 5, the electronic driver circuit EDC can be connected to a resonator element XO, which includes a crystal and zero, two or any arbitrary number of capacitors. When the electronic driver circuit EDC is connected to the resonator element XO, an electronic oscillator 1 is provided.

The electronic driver circuit EDC and the resonator element XO have so called 'negative' parts which are denoted with 'N', and so called 'positive' parts which are denoted with 'P'.

The electronic driver circuit EDC includes a synthesizer section SYN. According to the embodiment illustrated in Fig. 5, the synthesizer section SYN is configured to receive a reference signal XO_SIG from a resonator element XO. The synthesizer section SYN is configured to generate a synthesizer signal SYN_SIG having a synthesizer frequency SYN_F which is equal to, lower or higher than a reference frequency XO_F of the reference signal XO_SIG.N, XO_SIG.P, and having in particular a phase resolution below or equal to 90 degrees with respect to the reference signal XO_SIG.N, XO_SIG.P. The phase resolution is defined as 360 degrees with respect to the reference signal XO_SIG divided by the frequency multiplication ratio of the synthesizer SYN and further divided by the number of phases at the output of the synthesizer SYN.

The electronic driver circuit EDC includes a pulse injection section PJD.N, PJD.P which is configured to inject an injection signal INJ.N, INJ.P into the resonator element XO at an injection time T.N, T.P which is selected using the synthesizer signal SYN_SIG or using the synthesizer signal SYN_SIG and the reference signal XO_SIG.N, XO_SIG.P. The injection time T.N, T.P can be selected by comparing the synthesizer signal SYN_SIG with the reference signal XO_SIG.N, XO_SIG.P of the resonator element XO. The injection time T.N, T.P can be selected according to an impulse-sensitivity-function ISF, and can be selected to reduce phase noise, jitter and/or power consumption. For a synthesizer frequency SYN_F, which is higher than the reference frequency XO_F; or a synthesizer signal SYN_SIG having in particular a phase resolution below or equal to 90 degrees with respect to the reference signal XO_SIG, timing resolution is enhanced and the injection time T.N, T.P can be precisely selected. As illustrated in Fig. 5, the pulse injection section PJD.N, PJD.P can include any voltage, current or charge injection circuits which are configured to inject the injection signal INJ.N, INJ.P to the resonator element XO. The term 'precisely' means that the injection time T.N, T.P can be selected according to a predetermined timing resolution.

The oscillator 1 shown in Fig. 5 establishes bidirectional signal flow: while the resonator element XO provides a clean reference signal XO_SIG to the synthesizer section SYN, the synthesizer section SYN having synthesizer frequency SYN_F enables selecting the injection time T.N, T.P precisely to inject an injection signal INJ.N, INJ.P into the resonator element XO.

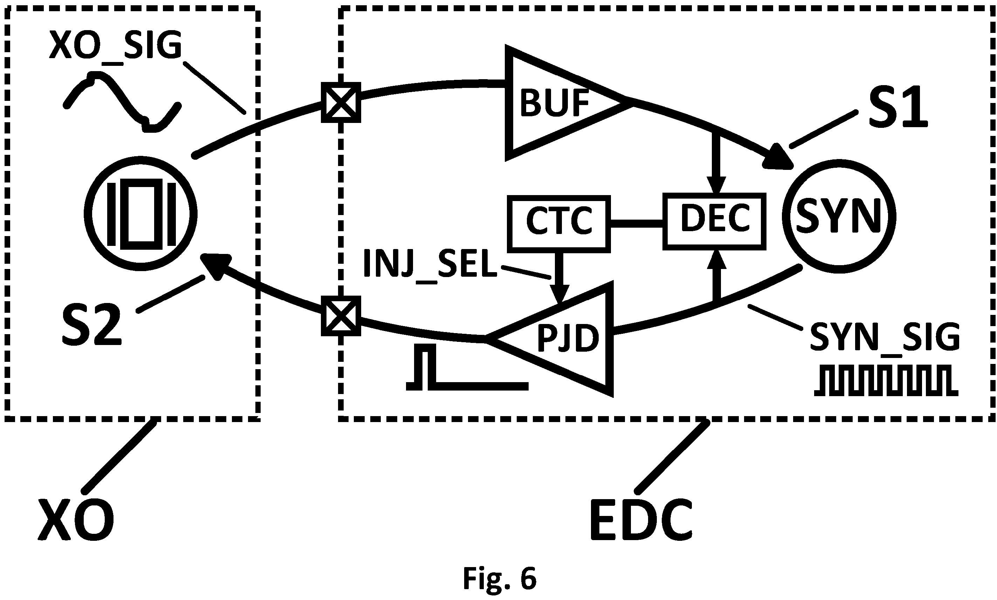

Fig. 6 shows possible method steps of operating an oscillator 1 according to the present invention. The electronic oscillator 1 includes a resonator element XO. In step S1, a reference signal XO_SIG is received from the resonator element XO and a synthesizer signal SYN_SIG is generated having a synthesizer frequency which is equal to, lower or higher than a reference frequency of the reference signal XO_SIG, and having in particular a phase resolution below or equal to 90 degrees with respect to the reference signal XO_SIG. In step S2, an injection signal is injected into the resonator element XO at an injection time which depends on the synthesizer signal SYN_SIG or which depends on the synthesizer signal SYN_SIG and the reference signal XO_SIG. In step S2, a detection circuit DEC can be used to find the low impulse-sensitivity-function ISF points for injection, or to determine if the utilized pulse injection timing T.N, T.P is accurate or not. In step S2, a control circuit CTC can be used to tune and/or control the pulse injection timing T.N, T.P according to the low impulse-sensitivity-function ISF points found by the detection circuit DEC.

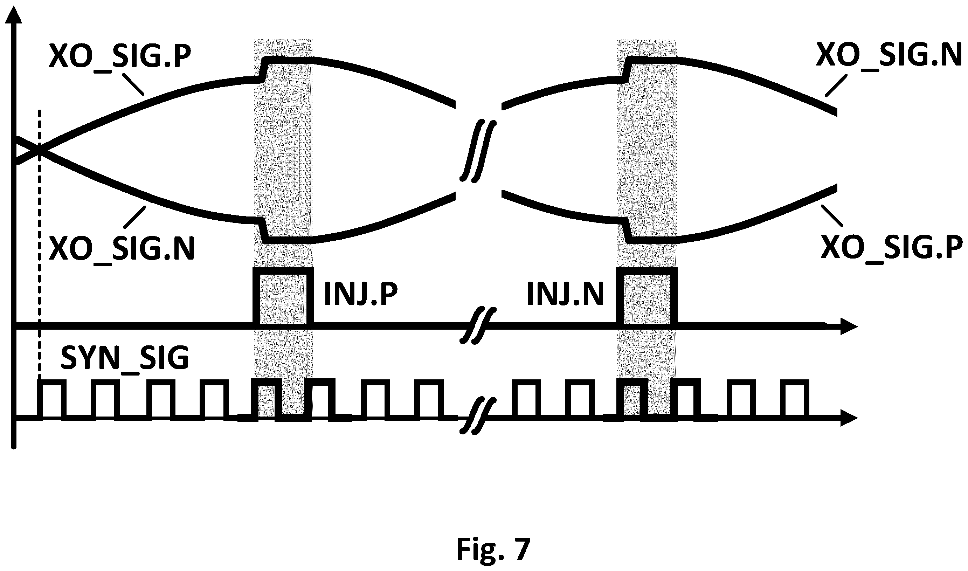

Fig. 7 shows possible signals of operating an electronic oscillator 1 according to the present invention. The signal SYN_SIG is synthesized by the electronic-driver-circuit EDC from the signal XO_SIG of the resonator element as the reference, which is then used by the detection and control circuits to generate injection pulses INJ.P and INJ.N that align with the low impulse-sensitivity-function ISF points of the resonator element XO to enable noise- and power-efficient energy injection to the resonator element XO.

Finally, it should be noted that the term "comprising" or "including" does not exclude other elements or steps and the "a" or "an" does not exclude a plurality. Also, elements described in association with different embodiments may be combined. It should also be noted that reference signs in the claims should not be construed as limiting the scope of the claims.

**LIST OF REFERENCE SIGNS**

| | | | |
|---|---|---|---|
| 1 | electronic oscillator | | |
| EDC | electronic driver circuit | XO | resonator element |
| SYN | synthesizer section | PJD.N, PJD.P | pulse injection section |
| PRC | Pierce driver circuit | | |
| INJ.N, INJ.P | injection signal | | |
| T.N, T.P | injection time | | |
| SYN_SIG | synthesizer signal | XO_SIG.N, XO_SIG.P | reference signal |
| SYN_F | synthesizer frequency | XO_F | reference frequency |
| ISF | Impulse-Sensitivity-Function | | |
| BUF | buffer circuit | | |
| PLL | phase-looked loop circuit | | |
| CO | controlled oscillator circuit | | |
| DEC | detection circuit | | |
| CTC | control circuit | | |
| DLY | delay-generating circuit | | |
| PUL | pulse-generating circuit | | |

## Claims

1. An electronic driver circuit (EDC) for driving a resonator element (XO) for providing an electronic oscillator (1), the driver circuit (EDC) comprising:
a synthesizer section (SYN) which is configured to receive a reference signal (XO_SIG.N, XO_SIG.P) from the resonator element (XO) and to generate a synthesizer signal (SYN_SIG) having a synthesizer frequency (SYN_F) which is equal to, lower or
higher than a reference frequency (XO_F) of the reference signal (XO_SIG.N, XO_SIG.P), and having in particular a phase resolution below or equal to 90 degrees with respect to the reference signal (XO_SIG.N, XO_SIG.P),
a pulse injection section (PJD.N, PJD.P) which is configured to inject an injection signal (INJ.N, INJ.P) into the resonator element (XO) at an injection time (T.N, T.P) which is selected using the synthesizer signal (SYN_SIG), or using the synthesizer signal (SYN_SIG) and the reference signal (XO_SIG.N, XO_SIG.P).

2. The electronic driver circuit (EDC) according to claim 1, wherein the injection signal (INJ.N, INJ.P) relates to one or more of a voltage signal, a current signal, and a charge signal.

3. The electronic driver circuit (EDC) according to claim 1 or 2, further configured to select the injection time (T.N, T.P) according to an impulse-sensitivity-function (ISF).

4. The electronic driver circuit (EDC) according to one of claims 1 to 3, further configured to select the injection time (T.N, T.P) to reduce one or more of phase noise, timing jitter, and power consumption.

5. The electronic driver circuit (EDC) according to one of claims 1 to 4, wherein the synthesizer frequency (SYN_F) is an integer multiple or a fractional multiple of the reference frequency (XO_F).

6. The electronic driver circuit (EDC) according to one of claims 1 to 5, wherein the electronic driver circuit (EDC) has an integrated, discrete or an integrated/discrete hybrid design.

7. The electronic driver circuit (EDC) according to one of claims 1 to 6, wherein the synthesizer section (SYN) includes one or more of a buffer circuit (BUF), a phase-looked-loop circuit (PLL), any other frequency synthesizing circuit and a controlled oscillator circuit (CO).

8. The electronic driver circuit (EDC) according to one of claims 1 to 7, further including a Pierce driver section (PRC) which is configured to start-up the electronic oscillator (1).

9. An electronic oscillator (1) comprising an electronic driver circuit (EDC) according to one of claims 1 to 8 connected to a resonator element (XO).

10. A printed circuit board comprising an electronic oscillator (1) according to claim 9.

11. A method of operating an electronic oscillator (1) comprising a resonator element (XO), the method comprising the steps:
receiving a reference signal (XO_SIG) from the resonator element (XO) and generating a synthesizer signal (SYN_SIG) having a synthesizer frequency which is equal to, lower or higher than a reference frequency of the reference signal (XO_SIG), and having in particular a phase resolution below or equal to 90 degrees with respect to the reference signal (XO_SIG),
injecting an injection signal into the resonator element (XO) at an injection time which depends on the synthesizer signal (SYN_SIG), or which depends on the synthesizer signal (SYN_SIG) and the reference signal (XO_SIG).
